# EUROPEAN PATENT SPECIFICATION

(11) **EP 3 477 689 B1**
(45) Date of publication and mention of the grant of the patent: **29.07.2020**
(21) Application number: 17815083.5
(22) Date of filing: 23.05.2017
(51) Int. Cl.: H01L 21/52, H01L 21/301, C09J 1/00, C09J 7/35, C09J 9/02, C09J 11/06, C08K 3/08

(54) **HEAT BONDING SHEET, AND HEAT BONDING SHEET WITH DICING TAPE**
WÄRMEVERBINDUNGSFOLIE UND WÄRMEVERBINDUNGSFOLIE MIT SÄGEFOLIE
FEUILLE DE THERMOCOLLAGE ET FEUILLE DE THERMOCOLLAGE AVEC RUBAN DE DÉCOUPAGE EN DÉS

(30) Priority: 24.06.2016 JP 2016125322
(43) Date of publication of application: 01.05.2019
(73) Proprietor: Nitto Denko Corporation, Ibaraki-shi, Osaka 567-8680 (JP)
(72) Inventor: HONDA,Satoshi, Ibaraki-shi Osaka 567-8680 (JP); SUGO,Yuki, Ibaraki-shi Osaka 567-8680 (JP); KAMAKURA,Nao, Ibaraki-shi Osaka 567-8680 (JP)
(74) Representative: Grünecker Patent- und Rechtsanwälte PartG mbB
(86) International application number: PCT/JP2017/019191
(87) International publication number: WO 2017/221614

(56) References cited:
- EP-A1- 3 239 258
- EP-A1- 3 358 605
- WO-A1-2016/031551
- WO-A1-2016/031551
- JP-A- 2003 249 471
- DATABASE WPI Week 201424 Thomson Scientific, London, GB; AN 2014-F50812 XP002792826, & JP 2014 055232 A (OSAKA MUNICIPAL TECH RES INST) 27 March 2014 (2014-03-27)

## Description

### TECHNICAL FIELD

The present invention relates to a thermal bonding sheet and a thermal bonding sheet with dicing tape.

### BACKGROUND ART

In production of semiconductor devices, the method of bonding a semiconductor element to an adherend such as a metallic lead frame (so-called bonding method) has been transited to methods by a solder and a resin paste from the conventional gold-silicon eutectic crystal that has been initially used. At present, a conductive resin paste is sometimes used.

However, in the method of using a conductive resin paste, deterioration in conductivity and nonuniformity in thickness of the paste due to generation of voids, and staining of the pad due to extrusion and the like can occur.

On the other hand, recently, power semiconductor devices that control or supply electric power have remarkably spread. A power semiconductor device has high calorific power because an electrical current usually flows through the device. Therefore, it is desired for a conductive adhesive that is used in a power semiconductor device to have high heat radiation property and low electric resistivity.

A power semiconductor device is required to operate at high speed with low loss. Conventionally, in a power semiconductor device, a semiconductor using Si such as IGBT (Insulated Gate Bipolar Transistor) or MOSFET (Metal-Oxide-Semiconductor Field-Effect Transistor) has been used. Recently, those using a semiconductor such as SiC or GaN have been developed and expected to extend in the future.

A semiconductor using SiC or GaN is featured by a large band gap, and high dielectric breakdown electric field, and is able to operate with low loss, at high speed and high temperature. Operation at high temperature is a merit in automobiles, small power converters and the like that operate in severe thermal environments. Since a semiconductor device having an application in a severe heat environment is assumed to operate at high temperature around 250°C, problems arise in heat characteristics and reliability with a solder or a conductive adhesive that is a conventional bonding/adhering material. In light of this, a paste material containing sintered metal particles has been proposed (see, Patent Document 1, for example). The paste material containing sintered metal particles contain nano-sized to micro-sized metal particles, and these metal particles melt at a temperature that is lower than the normal melting point due to the nano-size effect and sintering between particles progresses.

Patent Document 2 relates to a conductive adhesive film, comprising two or more types metal particles including at least copper, and a polymer that has a polydimethylsiloxane structure.

Patent Document 3 discloses a thermal bonding sheet comprising sinterable fine metal particles and a combination of polypropylene carbonate resin and MEK as an organic component.

Patent Document 4 relates a thermal bonding sheet comprising sinterable fine metal particles and a combination of a thermally decomposable binder resin and MEK as an organic component.

Patent Document 5 relates to a metal paste composition comprising a metal, aliphatic polycarbonate, an organic solvent and a basic substance.

### PRIOR ART DOCUMENTS

### PATENT DOCUMENTS

Patent Document 1: JP-A-2014-111800
Patent Document 2: WO 2016/031551 A
Patent Document 3: EP 3 239 258 A1
Patent Document 4: EP 3 358 605 A1
Patent Document 5: JP-A-2014-055232

### SUMMARY OF THE INVENTION

### PROBLEMS TO BE SOLVED BY THE INVENTION

However, since the paste material containing sintered metal particles is in a paste state as literally shown, the thickness is nonuniform as is the case with a conductive resin paste, resulting that bonding irregularity occurs, and in particular, the bonding reliability at high temperatures can deteriorate. Therefore, in order to solve the nonuniformity of the thickness and the problems caused by the nonuniformity, a technique of making the bonding material containing the sinterable metallic particles into a sheet shape is being studied.

As one of measures to impart formability to the bonding material, it has been studied that an organic binder which is a relatively high molecular weight material is added. Sintering of the sheet-like bonding material proceeds through the process of decomposition and disappearance of the organic components such as the organic binder, followed by sintering of the sinterable metallic particles.

However, when a polymer material typified by an organic binder and metal fine particles coexist, the decomposition temperature of the polymer material shifts to a higher temperature side in some cases. If the degree of the high temperature shift of the decomposition temperature becomes strong, the decomposition temperature of the polymer material may be about the same as or higher than the sintering temperature of the sinterable metallic particles. In this case, the polymer material remains without disappearing even during sintering of the sinterable metallic particles, and the polymer material that has not been disappeared inhibits sintering of the sinterable metallic particles, and as a result, sintering of the sinterable metallic particles becomes insufficient, which may cause deterioration of the bonding reliability of the power semiconductor device.

The present invention has been made in view of the above problems, and it is an object of the present invention to provide a thermal bonding sheet capable of suppressing inhibition of sintering of sinterable metallic particles by an organic component, thereby imparting sufficient bonding reliability to a power semiconductor device, and a thermal bonding sheet with a dicing tape having the thermal bonding sheet.

### MEANS FOR SOLVING THE PROBLEMS

As a result of diligent efforts to solve the aforementioned conventional problems, the present inventors found that the problems can be solved by employing the following constitution and accomplished the present invention.

To be more specific, the thermal bonding sheet in accordance with the present invention comprises a precursor layer that is to become a sintered layer by heating,
the precursor layer includes sinterable metallic particles and an organic component,
a 95% weight loss temperature of the organic component is 150°C or more and 300°C or less when thermogravimetry of the thermal bonding sheet is performed under an air atmosphere at a heating rate of 10°C/min, and
wherein the organic component includes an organic binder and a basic substance, wherein the organic binder is a thermally decomposable binder which is a material having a carbon concentration obtained by the energy dispersive X-ray analysis after temperature rise from 23°C to 400°C at a heating rate of 10°C/min in an air atmosphere of 15% by weight or less even when it is contained in the precursor layer, and
wherein the amount of the basic substance is from 1 to 150 parts by weight with respect to 100 parts by weight of the thermally decomposable binder.

In the thermal bonding sheet, a 95% weight loss temperature of the organic component included in the precursor layer upon heating under a specific condition is 150°C or more and 300°C or less. Since the organic component has a 95% weight loss temperature that is equal to or lower than the sintering temperature of the sinterable metallic particles, it is possible to cause decomposition and disappearance of most of organic components before sintering of the sinterable metallic particles, and sintering of the sinterable metallic particles can proceed smoothly.

The organic component includes an organic binder and a basic substance. Existence of the basic substance can accelerate decomposition and disappearance of the organic binder, therefore, sintering of the sinterable metallic particles can proceed more smoothly.

A 95% weight loss temperature of at least one of the basic substances is preferably 150°C or more and 300°C or less when thermogravimetry of the thermal bonding sheet is performed under an air atmosphere at a heating rate of 10°C/min. Since the basic substance has a 95% weight loss temperature that is comparable to that of the organic component, decomposition and disappearance of the organic component can proceed more efficiently and sufficiently. The basic substance contained in the thermal bonding sheet can be identified as follows, for example. Organic substances are first approximately identified by infrared spectroscopy (IR), and organic substances are taken out by solvent elution, centrifugation, etc., and structurally analyzed by nuclear magnetic resonance (NMR), gas chromatography, mass spectrometry (GC-MS) or the like to identify the molecular structure. The basic substance may be specified by other known methods.

The basic substance is preferably a tertiary amine in terms of decomposition property of the organic component and its appropriate 95% weight loss temperature.

A thermal bonding sheet with dicing tape according to another embodiment includes:
a dicing tape, and
the afore-mentioned thermal bonding sheet laminated on the dicing tape.

Since the thermal bonding sheet with dicing tape has a structure that a dicing tape and the thermal bonding sheet are integrated, a step for laminating the thermal bonding sheet with the dicing tape can be omitted. Since the thermal bonding sheet is provided, sintering of the sinterable metallic particles can proceed at a sufficient level, resulting in good bonding reliability.

### BRIEF DESCRIPTION OF THE DRAWINGS

Fig. 1 is a cross-sectional schematic view showing a thermal bonding sheet with dicing tape according to one embodiment of the present invention.
Fig. 2 is a cross-sectional schematic view showing a thermal bonding sheet with dicing tape according to other embodiment of the present invention.
Fig. 3 is a cross-sectional schematic view showing a thermal bonding sheet with both-side separators.
Fig. 4 is a cross-sectional schematic view for illustrating a method of manufacturing a semiconductor device according to one embodiment of the present invention.
Fig. 5 is a graph showing results of thermogravimetry about a thermal bonding sheet of Example 1.
Fig. 6A is an ultrasonic image showing results of bonding reliability test about a thermal bonding sheet of Example 2.
Fig. 6B is an ultrasonic image showing results of bonding reliability test about a thermal bonding sheet of Comparative Example 1.

### MODE FOR CARRYING OUT THE INVENTION

Hereinafter, embodiments of the thermal bonding sheet and the thermal bonding sheet with dicing tape of the present invention are described by referring to attached drawings. In part or whole of drawings, the part that is unnecessary for description is omitted, and some part is shown while it is scaled up or down for facilitating the description. The term indicating the positional relationship, such as up or down is merely used for facilitating the description and is not intended to limit the constitution of the present invention.

### (Thermal bonding sheet with dicing tape)

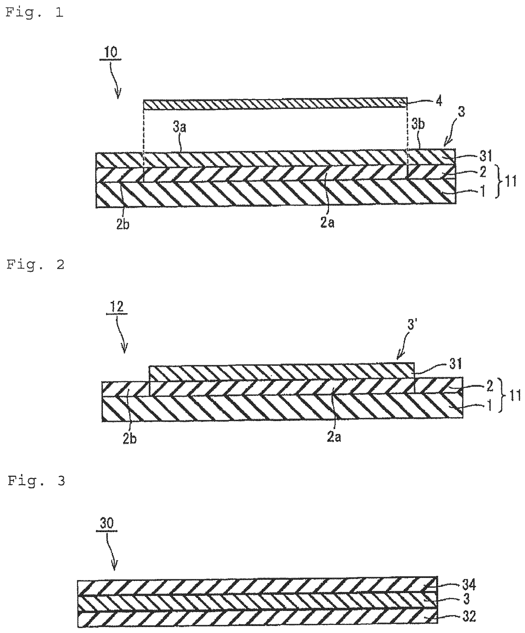

One exemplary thermal bonding sheet according to the present embodiment is in a state that the dicing tape is not bonded in the thermal bonding sheet with dicing tape as will be described below. Therefore, in the following, description is made for the thermal bonding sheet with dicing tape, and the thermal bonding sheet will be described in the description. Fig. 1 is a cross-sectional schematic view showing a thermal bonding sheet with dicing tape according to one embodiment of the present invention. Fig. 2 is a cross-sectional schematic view showing other thermal bonding sheet with dicing tape according to other embodiment of the present invention.

As shown in Fig. 1, a thermal bonding sheet with dicing tape 10 has such a structure that a thermal bonding sheet 3 is laminated on a dicing tape 11. The dicing tape 11 is structured by laminating a pressure-sensitive adhesive layer 2 on a base material 1, and the thermal bonding sheet 3 is disposed on the pressure-sensitive adhesive layer 2. Also, the thermal bonding sheet with dicing tape of the present invention may have such a structure that a thermal bonding sheet 3' is formed only in a work attaching part as in a thermal bonding sheet with dicing tape 12 shown in Fig. 2.

### (Thermal bonding sheet)

The thermal bonding sheet 3, 3' is in a sheet form. The sheet form rather than the paste form can provide excellent thickness uniformity and handleability.

The thermal bonding sheet 3, 3' according to the present embodiment includes a precursor layer 31 that is to become a sintered layer by heating. In the present embodiment, description is made for the case where the thermal bonding sheet contains only one layer of a precursor layer that is to become a sintered layer by heating, however, the present invention is not limited to this case. The precursor layer that is to become a sintered layer by heating may have such a structure that a plurality of precursor layers are laminated.

Also, in the present embodiment, description is made for the case where the thermal bonding sheet includes a precursor layer that is to become a sintered layer by heating, however, the present invention is not limited to this case. The thermal bonding sheet of the present invention may include two or more layers. For example, the thermal bonding sheet may have such a structure that a precursor layer that is to become a sintered layer by heating, and other layer (layer that is not to become a sintered layer by heating) are laminated.

That is, it is only required that the thermal bonding sheet according to the present invention has at least a precursor layer that is to become a sintered layer by heating, and other constitution is not particularly limited.

### (Precursor layer that is to become sintered layer by heating)

The precursor layer 31 that is to become a sintered layer by heating (hereinafter, also simply referred to as "precursor layer 31") includes sinterable metallic particles and an organic component (each component will be described in detail later.). In the precursor layer 31, a 95% weight loss temperature of the organic component is 150°C or more and 300°C or less when thermogravimetry of the thermal bonding sheet is performed under an air atmosphere at a heating rate of 10°C/min. Preferably, the 95% weight loss temperature is 200°C or more, and more preferably, the 95% weight loss temperature is 250°C or more. On the other hand, preferably, the 95% weight loss temperature is 290°C or less, and more preferably, the 95% weight loss temperature is 280°C or less. When the 95% weight loss temperature is heated to a temperature within the above mentioned range, at least 95% of weight of the organic component in the precursor layer disappears. Since the organic component has a 95% weight loss temperature that is equal to or lower than the sintering temperature of the sinterable metallic particles, it is possible to cause decomposition and disappearance of most of organic components before sintering of the sinterable metallic particles, and sintering of the sinterable metallic particles can proceed smoothly. If the 95% weight loss temperature is too low, the organic component unintentionally decomposes by heat load before thermal bonding, and desired sheet properties cannot be obtained. If the 95% weight loss temperature is too high, the organic component exists even at the time of sintering of the sinterable metallic particles to inhibit the sintering, leading to decrease in bonding reliability.

The precursor layer 31 has an average thickness of 5 µm to 200 µm, preferably 10 µm to 150 µm, more preferably 15 µm to 100 µm. By setting the average thickness of the precursor layer 31 before heating within the above range, it is possible to maintain the sheet form and secure the thickness uniformity.

The precursor layer 31 has a tensile modulus obtained by the following tensile testing method of preferably 10 MPa to 3000 MPa, more preferably 12 MPa to 2900 MPa, further preferably 15 MPa to 2500 MPa.

Tensile testing method:
(1) As a test sample, a thermal bonding sheet (thermal bonding sheet for tensile test) having a thickness of 200 µm, a width of 10 mm, and a length of 40 mm is prepared,
(2) a tensile test is conducted with a distance between chucks of 10 mm, a tensile speed of 50 mm/min, at 23°C, and
(3) the inclination of the linear part of the obtained stress-strain chart is determined as a tensile modulus.

When the tensile modulus of the precursor layer 31 is 10 MPa or more, it is possible to further prevent the material forming the thermal bonding sheet from protruding or climbing up on the chip surface at the time of die attachment. When the tensile modulus is 3000 MPa or less, it is possible to fix the semiconductor wafer, for example, at the time of dicing.

The precursor layer 31 has a carbon concentration obtained by the energy dispersive X-ray analysis after temperature rise from 23°C to 400°C at a heating rate of 10°C/min in an air atmosphere of 15% by weight or less, preferably 12% by weight or less, more preferably 10% by weight or less. When the carbon concentration is 15% by weight or less, almost no organic matter exists in the precursor layer 31 after temperature rise to 400°C. As a result, after the thermal bonding step, excellent heat resistance, and high reliability and heat characteristics even in high temperature environment are achieved.

The precursor layer 31 shows a peak observed in a differential thermal analysis from 23°C to 500°C at a heating rate of 10°C/min in an air atmosphere existing preferably in the range of 150 to 350°C, more preferably in the range of 170 to 320°C, further preferably in the range of 180 to 310°C. When the peak exists in the range of 150 to 350°C, it is deemed that the organic matter (such as a resin component forming the precursor layer 31) is thermally decomposed in this temperature range. As a result, the heat resistance after the thermal bonding step is more excellent.

### (Sinterable metallic particles)

As the sinterable metallic particles, an aggregate of metallic particles can be favorably used. Examples of the metallic fine particles include fine particles of metal. Examples of the metal include gold, silver, copper, silver oxide, and copper oxide. Among these, at least one selected from the group consisting of silver, copper, silver oxide, and copper oxide is preferred. When the metallic fine particles are at least one selected from the group consisting of silver, copper, silver oxide and copper oxide, the thermal bonding can be achieved more favorably.

The average particle size of the sinterable metallic particles is preferably 0.0005 µm or more, more preferably 0.001 µm or more. Examples of the lower limit of the average particle size include 0.01 µm, 0.05 µm, and 0.1 µm. On the other hand, the average particle size of the sinterable metallic particles is preferably 30 µm or less, more preferably 25 µm or less. Examples of the upper limit of the average particle size include 20 µm, 15 µm, 10 µm, and 5 µm.

The average particle size of the sinterable metallic particles is determined in the following method. To be more specific, the sinterable metallic particles are observed by SEM (scanning electron microscope) and an average particle size is determined. The SEM observation is preferably conducted with a 5000-fold magnification for the sinterable metallic particles of micro size, and with a 50000-fold magnification for the submicron-sized sinterable metallic particles, and with a 300000-fold magnification for the nano-sized sinterable metallic particles.

The shape of the sinterable metallic particles is not particularly limited, and is, for example, globular, bar-like, scaly, or indefinite.

The precursor layer 31 preferably includes sinterable metallic particles in the range of 60 to 98% by weight with respect to the entire precursor layer 31. The content of the sinterable metallic particles is more preferably in the range of 65 to 97% by weight, and further preferably in the range of 70 to 95% by weight. When sinterable metallic particles are contained in the range of 60 to 98% by weight, sinterable metallic particles can be sintered or melt to bond two objects (for example, a semiconductor chip and a lead frame).

### (Organic component)

The organic component includes an organic binder and a basic substance. Decomposition and disappearance of the organic binder can be accelerated by the presence of the basic substance, and the sinterable metallic particles can be sintered more smoothly.

It is preferred that the precursor layer 31 contains, as the organic component, a thermally decomposable binder that is solid at 23°C. When the thermally decomposable binder is contained, the sheet form is easy to be maintained before the thermal bonding step. Also it is easy to be thermally decomposed in the thermal bonding step.

In this description, "solid" has a viscosity at 23°C, determined by viscosity measurement using a rheometer of more than 100,000 Pa•s.

In the present description, "thermally decomposable binder" means a binder that can be thermally decomposed in the thermal bonding step. It is preferred that the thermally decomposable binder little remains in the sintered layer (precursor layer 31 after heating) after the thermal bonding step. The thermally decomposable binder is a material having a carbon concentration obtained by the energy dispersive X-ray analysis after temperature rise from 23°C to 400°C at a heating rate of 10°C/min in an air atmosphere of 15% by weight or less even when it is contained in the precursor layer 31. For example, by employing a material that is easier to thermally decompose as the thermally decomposable binder, it is possible to make the thermally decomposable binder little remain in the sintered layer (precursor layer 31 after heating) after the thermal bonding step even if the content of the thermally decomposable binder is relatively large.

Examples of the thermally decomposable binder include polycarbonate, acryl resin, ethyl cellulose, and polyvinyl alcohol. These materials can be used solely or in combination of two or more. Among these, polycarbonate is preferred from the view point of high thermal decomposability.

While the polycarbonate is not particularly limited as far as it can thermally decompose in the thermal bonding step, examples of the polycarbonate include aliphatic polycarbonates that do not contain an aromatic compound (for example, benzene ring) between carbonate ester groups (-O-CO-O-) of the main chain, and are composed of an aliphatic chain, and aromatic polycarbonates that contain an aromatic compound between carbonate ester groups (-O-COO-) of the main chain. Among these, aliphatic polycarbonates are preferred.

Examples of the aliphatic polycarbonates include polyethylene carbonate, and polypropylene carbonate. Among these, polypropylene carbonate is preferred from the view point of solubility in an organic solvent in preparation of vanish for forming a sheet.

Examples of the organic polycarbonate include those containing a bisphenol A structure in the main chain.

The polycarbonate has a weight average molecular weight of preferably in the range of 10,000 to 1,000,000. The weight average molecular weight is a value that is measured by GPC (gel permeation chromatography) and calculated by conversion by polystyrene.

Examples of the acryl resin include polymers (acryl copolymers) composed of one or two or more esters of acrylic acid or methacrylic acid having a straight-chain or branched alkyl group having 30 or less carbons, particularly 4 to 18 carbons as far as they can thermally decompose in the thermal bonding step. Examples of the alkyl group include a methyl group, an ethyl group, a propyl group, an isopropyl group, an n-butyl group, a t-butyl group, an isobutyl group, an amyl group, an isoamyl group, a hexyl group, a heptyl group, a cyclohexyl group, a 2-ethylhexyl group, an octyl group, an isooctyl group, a nonyl group, an isononyl group, a decyl group, an isodecyl group, a undecyl group, a lauryl group, a tridecyl group, a tetradecyl group, a stearyl group, an octadecyl group, or a dodecyl group.

Examples of other monomer that forms a polymer (acryl copolymer) include, but are not limited to, carboxyl group-containing monomers such as acrylic acid, methacrylic acid, carboxyethyl acrylate, carboxypentyl acrylate, itaconic acid, maleic acid, fumaric acid or crotonic acid, acid anhydride monomers such as maleic anhydride or itaconic anhydride, hydroxyl group-containing monomers such as (meth)acrylate 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate or (4-hydroxymethylcyclohexyl)-methylacrylate, sulfonic group-containing monomers such as styrenesulfonic acid, allylsulfonic acid, 2-(meth)acrylamide-2-methylpropanesulfonic acid, (meth)acrylamide propanesulfonic acid, sulfopropyl (meth)acrylate or (meth)acryloyloxynaphthalenesulfonic acid, or phosphoric group-containing monomers such as 2-hydroxyethylacryloylphosphate.

Among the acryl resins, those having a weight average molecular weight of 10000 to 1000000 are more preferred, and those having a weight average molecular weight of 30000 to 700000 are further preferred. This is because those satisfying the numerical ranges described above are excellent in adhesion before the thermal bonding step, and in thermal decomposition during the thermal bonding step. The weight average molecular weight is a value that is measured by GPC (gel permeation chromatography) and calculated by conversion by polystyrene.

Among the acryl resin, acryl resins that thermally decompose at 200°C to 400°C are preferred.

The basic substance is not particularly limited, and examples thereof include an inorganic base and an organic base. Examples of the inorganic base include metal hydroxides such as sodium hydroxide, potassium hydroxide and calcium hydroxide, metal hydrides such as lithium hydride and sodium hydride, metal oxides such as sodium oxide, potassium oxide, calcium oxide, metal weak acid salts such as sodium carbonate, potassium carbonate, sodium hydrogencarbonate and sodium phosphate, ammonia and the like. Examples of the organic base include secondary amines such as diethanolamine, tertiary amines such as trihexylamine, triheptylamine, trioctylamine, triethanolamine, 1,8-diazabicyclo[5.4.0] undeca-4-ene (DBU), 1,5-diazabicyclo[4.3.0] non-5-ene (DBN), phosphazene compounds such as 2-tert-butylimino-2-diethylamino-1,3-dimethylperhydro-diaza-2-phospholine (BEMP), tert-butylimino-tris(dimethylamino) phosphorane (tBu-P1), metal alkoxide compounds such as sodium methoxide, potassium tert-butoxide, and the like.

A substance that generates these bases may be added as a basic substance. Examples thereof include a photobase generator and a thermal base generator. Examples of the photobase generator include guanidinium 2-(3-benzoylphenyl) propionate, E-1-[3-(2-hydroxyphenyl)-2-propenoyl]piperidine, 1-(anthraquinon-2-yl)ethyl imidazole carboxylate and the like. Examples of the thermal base generator include N-(2-nitrobenzyloxycarbonyl)imidazole, N-(3-nitrobenzyloxycarbonyl)imidazole and the like.

When thermogravimetry of the thermal bonding sheet is performed under an air atmosphere at a heating rate of 10°C/min, a 95% weight loss temperature of at least one of the basic substances is preferably 150°C or more and 300°C or less, more preferably 200°C or more and 280°C or less. Since the basic substance (at least one of the basic substances when there are a plurality of basic substances) has a 95% weight loss temperature that is comparable to that of the organic component, decomposition and disappearance of the organic component can proceed more efficiently and sufficiently.

Among these basic substances, tertiary amines such as trioctylamine and triethanolamine are preferably used from the viewpoints of affinity with the organic components, decomposability of organic components by bases, and thermal stability. Each of the above basic substances may be used alone or in combination of two or more kinds.

Although a compounding amount of the basic substance is not particularly limited, the compounding amount is preferably 1 to 150 parts by weight, more preferably 10 to 100 parts by weight with respect to 100 parts by weight of the thermally decomposable binder.

The precursor layer 31 may contain, for example, a plasticizer as appropriate.

The thermal bonding sheets 3, 3' can be produced in an ordinary method. For example, a vanish containing aforementioned components for forming the precursor layer 31 is prepared, and the vanish is applied on a base separator to have a predetermined thickness to form an applied film, and then the applied film is dried to produce the thermal bonding sheets 3, 3'.

Preferred examples of the solvent used for the vanish include, but are not limited to, organic solvents and alcohol solvents capable of uniformly dissolving, kneading or dispersing the components. Examples of the organic solvents include ketone-based solvents such as dimethylformamide, dimethylacetamide, N-methylpyrrolidone, acetone, methylethylketone and cyclohexanone, toluene, and xylene. Examples of the alcohol solvents include ethylene glycol, diethylene glycol, 1,2-propanediol, 1,3-propanediol, 1,2-butanediol, 1,3-butanediol, 1,4-butanediol, 2-butene-1,4-diol, 1,2,6-hexanetriol, glycerin, octanediol, 2-methyl-2,4-pentanediol, and terpineol.

The applying method is not particularly limited. Examples of the method for applying a solvent include a die coater, a gravure coater, a roll coater, a reverse coater, a comma coater, a pipe doctor coater, and screen printing. Among these, a die coater is preferred from the view point of high uniformity of application thickness. The drying condition of the applied film is not particularly limited, and for example, the applied film can be dried, for example, at a drying temperature of 70 to 160°C for a drying time of 1 to 5 minutes. Even after drying the applied film, the solvent fails to entirely vaporize and remains in the coating film depending on the solvent.

Ratio of each component that forms the precursor layer 31 may change depending on the drying condition, therefore, it is preferred to set the drying condition so that the contents of the metallic fine particles and the thermally decomposable binder in the precursor layer 31 are desired amounts.

As the base separator, a plastic film or paper having a surface coated with a release agent such as polyethylene terephthalate (PET), polyethylene, polypropylene, a fluorine-based release agent, a long-chain alkyl acrylate-based release agent can be used.

As the manufacturing method of the thermal bonding sheet 3, 3', for example, a method of mixing the components, and press-molding the obtained mixture to produce the thermal bonding sheet 3, 3' is also preferred. Examples of the mixer include a planetary mixer.

### (Dicing tape)

The dicing tape 11 is formed by laminating the pressure-sensitive adhesive layer 2 on the base material 1.

The base material 1 is a base for the strength of the thermal bonding sheet with dicing tape 10, 12, and is preferably ultraviolet transmissive. Examples of the base material 1 include polyolefin such as low-density polyethylene, straight chain polyethylene, intermediate-density polyethylene, high-density polyethylene, very low-density polyethylene, random copolymer polypropylene, block copolymer polypropylene, homopolypropylene, polybutene, and polymethylpentene; an ethylene-vinylacetate copolymer; an ionomer resin; an ethylene(meth)acrylic acid copolymer; an ethylene(meth)acrylic acid ester (random or alternating) copolymer; an ethylene-butene copolymer; an ethylene-hexene copolymer; polyurethane; polyester such as polyethyleneterephthalate and polyethylenenaphthalate; polycarbonate; polyetheretherketone; polyetherimide; polyamide; whole aromatic polyamides; polyphenylsulfide; aramid (paper); glass; glass cloth; a fluorine resin; polyvinyl chloride; polyvinylidene chloride; a cellulose resin; a silicone resin; metal (foil); and paper.

Further, the material of the base material 1 includes a polymer such as a cross-linked body of the above resins. The above plastic film may be also used unstreched, or may be also used on which a monoaxial or a biaxial stretching treatment is performed depending on necessity. According to resin sheets in which heat shrinkable properties are given by the stretching treatment, etc., the adhesive area of the pressure sensitive adhesive layer 2 and the thermal bonding sheet 3, 3' is reduced by thermally shrinking the base material 1 after dicing, and the recovery of the semiconductor chips can be facilitated.

A known surface treatment such as a chemical or physical treatment such as a chromate treatment, ozone exposure, flame exposure, high voltage electric exposure, and an ionized radiation treatment, and a coating treatment by an undercoating agent (for example, a tacky substance described later) can be performed on the surface of the base material 1 in order to improve adhesiveness, holding properties, etc. with the adjacent layer.

The thickness of the base material 1 can be appropriately decided without limitation particularly. However, it is generally about 5 to 200 µm.

Examples of the pressure-sensitive adhesive layer 2 include, but are not limited to, common pressure-sensitive adhesives such as an acryl-based pressure-sensitive adhesive or a rubber-based pressure-sensitive adhesive. An acrylic pressure-sensitive adhesive having an acrylic polymer as a base polymer is preferable as the pressure-sensitive adhesive from the point of view of clean washing properties of an electric part such as a semiconductor wafer and glass that dislike contamination with ultra pure water and an organic solvent such as alcohol.

Examples of the acrylic polymer include acrylic polymers each comprising, as one or more monomer components, one or more selected from alkyl esters of (meth)acrylic acid (for example, linear and branched alkyl esters thereof each having an alkyl group having 1 to 30 carbon atoms, in particular, 4 to 18 carbon atoms, such as methyl ester, ethyl ester, propyl ester, isopropyl ester, butyl ester, isobutyl ester, s-butyl ester, t-butyl ester, pentyl ester, isopentyl ester, hexyl ester, heptyl ester, octyl ester, 2-ethylhexyl ester, isooctyl ester, nonyl ester, decyl ester, isodecyl ester, undecyl ester, dodecyl ester, tridecyl ester, tetradecyl ester, hexadecyl ester, octadecyl ester, and eicosyl ester thereof) and cycloalkyl esters of (meth)acrylic acid (for example, cyclopentyl ester and cyclohexyl ester thereof). The wording "esters of (meth)acrylic acid" means esters of acrylic acid and/or methacrylic acid. All of the words including "(meth)" in connection with the present invention have an equivalent meaning.

The acrylic polymer may optionally contain a unit corresponding to a different monomer component copolymerizable with the above-mentioned alkyl ester of (meth)acrylic acid or cycloalkyl ester thereof in order to improve the cohesive force, heat resistance or some other property of the polymer. Examples of such a monomer component include carboxyl-containing monomers such as acrylic acid, methacrylic acid, carboxyethyl (meth)acrylate, carboxypentyl (meth)acrylate, itaconic acid, maleic acid, fumaric acid, and crotonic acid; acid anhydride monomers such as maleic anhydride, and itaconic anhydride; hydroxyl-containing monomers such as 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate, and (4-hydroxylmethylcyclohexyl)methyl (meth)acrylate; sulfonic acid group containing monomers such as styrenesulfonic acid, allylsulfonic acid, 2-(meth)acrylamide-2-methylpropanesulfonic acid, (meth)acrylamidepropanesulfonic acid, sulfopropyl (meth)acrylate, and (meth)acryloyloxynaphthalenesulfonic acid; phosphoric acid group containing monomers such as 2-hydroxyethylacryloyl phosphate; acrylamide; and acrylonitrile. These copolymerizable monomer components may be used alone or in combination of two or more thereof. The amount of the copolymerizable monomer(s) to be used is preferably 40% or less by weight of all the monomer components.

For crosslinking, the acrylic polymer can also contain multifunctional monomers if necessary as the copolymerizable monomer component. Such multifunctional monomers include hexane diol di(meth)acrylate, (poly)ethylene glycol di(meth)acrylate, (poly)propylene glycol di(meth)acrylate, neopentyl glycol di(meth)acrylate, pentaerythritol di(meth)acrylate, trimethylol propane tri(meth)acrylate, pentaerythritol tri(meth)acrylate, dipentaerythritol hexa(meth)acrylate, epoxy (meth)acrylate, polyester (meth)acrylate, urethane (meth)acrylate etc. These multifunctional monomers can also be used as a mixture of one or more thereof. From the viewpoint of adhesiveness etc., the use amount of the multifunctional monomer is preferably 30 wt% or less based on the whole monomer components.

The acrylic polymer can be obtained by polymerizing a single monomer or a mixture of monomers of two types or more. The polymerization can be performed with any of polymerization methods such as solution polymerization, emulsification polymerization, bulk polymerization, and suspension polymerization. The content of a low molecular weight material is preferably small from the point of view of prevention of contamination to a clean adherend. In this respect, the number average molecular weight of the acrylic polymer is preferably about 100,000 or more, and more preferably about 200,000 to 3,000,000, and especially preferably about 300,000 to 1,000,000.

Further, an external crosslinking agent can be suitably adopted to the pressure-sensitive adhesive in order to increase the number average molecular weight of an acrylic polymer that is a base polymer, etc. Specific examples of the external crosslinking method include methods of reacting by adding a so-called crosslinking agents such as a polyisocyanate compound, an epoxy compound, an aziridine compound, and a melamine based crosslinking agent. When the external crosslinking agent is used, the amount to be used can be suitably determined by the balance with the base polymer that is to be crosslinked and by the purpose of use as a pressure-sensitive adhesive. In general, it is preferably mixed at about 5 parts by weight or less, and more preferably 0.1 to 5 parts by weight to 100 parts by weight of the base polymer. Besides the above-described components, an additive such as conventionally known various tackifiers and antioxidants may be used in the pressure-sensitive adhesive depending on necessity.

The pressure sensitive adhesive layer 2 is constituted by containing a radiation curable pressure sensitive adhesive. The radiation curable pressure sensitive adhesive can easily decrease its adhesive strength by increasing the degree of crosslinking by irradiation with radiation such as ultraviolet-ray. By radiating only a part 2a corresponding to the work attaching part of the pressure sensitive adhesive layer 2 shown in Fig. 2, a difference of the adhesive strength to another part 2b can be also provided.

Also, by curing the radiation curable pressure-sensitive adhesive layer 2 together with the thermal bonding sheet 3' shown in Fig. 2, the part 2a where the adhesive strength is significantly reduced can be easily formed. Since the thermal bonding sheet 3' is attached to the part 2a that has been cured and has reduced adhesive strength, the boundary in the pressure-sensitive adhesive layer 2 between the part 2a and the thermal bonding sheet 3' has the property of easily peeling off at the time of pickup. On the other hand, the part that has not been irradiated with radiation has sufficient adhesive strength, and forms the part 2b. Irradiation of the pressure-sensitive adhesive layer can be conducted after dicing and before pickup.

As described above, in the pressure-sensitive adhesive layer 2 of the thermal bonding sheet with dicing tape 10 shown in Fig. 1, the part 2b formed of the uncured radiation curable pressure-sensitive adhesive adheres to the thermal bonding sheet 3, and the holding force at the time of dicing can be secured. In such a way, the radiation curable pressure-sensitive adhesive can support the thermal bonding sheet 3 for fixing the chip-like work (e.g., semiconductor chip) onto an adherend such as a substrate with good balance of adhesion and peeling. In the pressure-sensitive adhesive layer 2 of the thermal bonding sheet with dicing tape 11 shown in Fig. 2, the part 2b can fix the wafer ring.

A radiation curable pressure-sensitive adhesive having a radiation curable functional group such as a carbon-carbon double bond and having adherability can be used without special limitation. Example of the radiation curable pressure-sensitive adhesive include an additive-type radiation curable pressure-sensitive adhesive in which a radiation curable monomer component or oligomer component is mixed into a general pressure-sensitive adhesive such as an acrylic pressure-sensitive adhesive or a rubber-based pressure-sensitive adhesive.

The radiation-curing monomer component to be compounded includes, for example, urethane oligomer, urethane (meth)acrylate, trimethylol propane tri(meth)acrylate, tetramethylol methane tetra(meth)acrylate, pentaerythritol tri(meth)acrylate, pentaerythritol tetra(meth)acrylate, dipentaerythritol monohydroxy penta(meth)acrylate, dipentaerythritol hexa(meth)acrylate, 1,4-butane diol di(meth)acrylate, tetraethylene glycol di(meth)acrylate, 1,6-hexane diol (meth)acrylate, neopentyl glycol di(meth)acrylate etc.; ester acrylate oligomers; and isocyanurates or isocyanurate compounds such as 2-propenyl-3-butenyl cyanurate, tris(2-methacryloxyethyl) isocyanurate etc. The radiation-curing oligomer component includes various acrylate oligomers such as those based on urethane, polyether, polyester, polycarbonate, polybutadiene etc., and their molecular weight is preferably in the range of about 100 to 30000. For the compounded amount of the radiation-curable monomer component or oligomer component, the amount of which the adhesive strength of the pressure-sensitive adhesive layer can be decreased can be determined appropriately depending on the type of the above-described pressure-sensitive adhesive layer. In general, the compounded amount is, for example, 5 to 500 parts by weight, and preferably about 40 to 150 parts by weight relative to 100 parts by weight of the base polymer such as an acrylic polymer constituting the pressure-sensitive adhesive.

Besides the additive-type radiation curable pressure-sensitive adhesive that is explained above, examples of the radiation curable pressure-sensitive adhesive include an internal radiation curable pressure-sensitive adhesive in which a polymer having a carbon-carbon double bond in the polymer side chain, in the main chain, or in the ends of the main chain is used as the base polymer. The internal radiation curable pressure-sensitive adhesive does not have to contain an oligomer component that is a low molecular weight component, etc., or it does not contain much of the component. Therefore, it is preferable because a pressure-sensitive adhesive layer having a stable layer structure can be formed without the oligomer component, etc. shifting in the pressure-sensitive adhesive with the passage of time.

A base polymer having a carbon-carbon double bond and having adherability can be used without limitation. As such base polymer, a polymer having an acrylic polymer as a basic skeleton is preferable. Examples of the basic skeleton of the acrylic polymer include the acrylic polymers shown above.

A method of introducing a carbon-carbon double bond into the acrylic polymer is not especially limited, and various methods can be adopted. However, a molecular design is easy when the carbon-carbon double bond is introduced in the polymer side chain. For example, a method of copolymerizing a monomer having a functional group with an acrylic polymer and then performing condensation or an addition reaction on a compound having a functional group that can react with the functional group of the monomer and having a carbon-carbon double bond while maintaining the radiation curing property of a carbon-carbon double bond.

Examples of the combination of these functional groups include a carboxylic acid group and an epoxy group, a carboxylic acid group and an aziridyl group, and a hydroxyl group and an isocyanate group. Among these combinations of the functional group, the combination of a hydroxyl group and an isocyanate group is preferable because of ease of pursuing the reaction. Further, the functional group may be in any side of the acrylic polymer and the above-describe compounds as long as it is a combination of these functional groups so that the acrylic polymer having a carbon-carbon double bond is produced. However, the case where the acrylic polymer has a hydroxyl group and the above-described compound has an isocyanate group is preferable in the above-described preferable combination. In this case, examples of the isocyanate compound having a carbon-carbon double bond include methacryloylisocyanate, 2-methacryloyloxyethylisocyanate, and m-isopropenyl-a,a-dimethylbenzylisocyanate. Further, a polymer in which the hydroxyl group containing the monomers exemplified above and an ether based compound of 2-hydroxyethylvinylether, 4-hydroxybutylvinylether, diethylene glycol monovinylether, etc. are copolymerized can be used as the acrylic polymer.

A base polymer having a carbon-carbon double bond (especially, acrylic polymer) can be used alone as the internal-type radiation curable pressure-sensitive adhesive. However, the above-described radiation curable monomer component or oligomer component can be mixed to an extent that its characteristics do not deteriorate. The amount of the radiation curable oligomer component, etc. is normally within 30 parts by weight and preferably in the range of 0 to 10 parts by weight to 100 parts by weight of the base polymer.

A photopolymerization initiator is contained in the internal radiation curable pressure sensitive adhesive in the case of curing with radiation such as ultraviolet rays. Examples of the photopolymerization initiator include an α-ketol based compound such as 4-(2-hydroxyethoxy)phenyl(2-hydroxy-2-propyl)ketone, α-hydroxy-α,α'-dimethylacetophenone, 2-methyl-2-hydroxypropyophenone, and 1-hydroxycyclohexylphenylketone; an acetophenone based compound such as methoxyacetophenone, 2,2-dimethoxy-2-phenylcetophenone, 2,2-diethoxyacetophenone, and 2-methyl-1-[4-(methylthio)-phenyl]-2-morpholinopropane-1; a benzoinether based compound such as benzoinethylether, benzoinisopropylether, and anisoinmethylether; a ketal based compound such as benzyldimethylketal; an aromatic sulfonylchloride based compound such as 2-naphthalenesulfonylchloride; a photoactive oxime based compound such as 1-phenone-1,1-propanedion-2-(o-ethoxycarbonyl)oxime; a benzophenone based compound such as benzophenone, benzoylbenzoic acid and 3,3'-dimethyl-4-methoxybenzophenone; a thioxanthone based compound such as thioxanthone, 2-chlorothioxanthone, 2-methylthioxanthone, 2,4-dimethylthioxanthone, isopropylthioxanthone, 2,4-dichlorothioxanthone, 2,4-diethylthioxanthone, and 2,4-diisopropylthioxanthone; camphorquinone; halogenated ketone; acylphosphinoxide; acylphosphonate and the like. The compounding amount of the photopolymerization initiator is about 0.05 to 20 parts by weight for example based on 100 parts by weight of the base polymer such as an acryl polymer constituting the pressure sensitive adhesive.

Further, examples of the radiation curable pressure sensitive adhesive include a rubber based pressure sensitive adhesive and acryl-based pressure sensitive adhesive containing an addition polyerizable compound having two or more unsaturated bonds, a photopolymerizable compound such as alkoxysilane having an epoxy group, and a photopolymerization initiator such as a carbonyl compound, an organic sulfur compound, a peroxide, an amine salt-based and an onium salt based compound, which are disclosed in JP-A No. 60-196956.

The radiation curable pressure-sensitive adhesive layer 2 can contain a compound that colors by irradiation as necessary. By containing the compound that colors by irradiation in the pressure-sensitive adhesive layer 2, only the part that is irradiated with radiation can be colored. In other words, the part 2a corresponding to a work attaching part 3a shown in Fig. 1 can be colored. Therefore, it is possible to rapidly determine whether the pressure-sensitive adhesive layer 2 is irradiated with radiation by visual inspection, and the work attaching part 3a is easy to recognize, and bonding of the work is easy. In detecting a semiconductor chip by an optical sensor or the like, the detection accuracy is improved, and a malfunction does not occur at the time of pickup of the semiconductor chip. The compound that colors by irradiation is a compound that is colorless or light-colored before irradiation, but becomes colored by irradiation, and, for example, a leuco dye can be recited. The use rate of the compound that colors by irradiation can be set appropriately.

The thickness of the pressure sensitive adhesive layer 2 is not particularly limited. However, it is preferably about 1 to 50 µm from the viewpoints of compatibility of chipping prevention of the chip cut face and holding the fixation of the adhesive layer, etc. It is preferably 2 to 30 µm, and further preferably 5 to 25 µm.

The dicing tape 11 according to the present embodiment is manufactured for example as follows. First, the base material 1 can be formed with a conventionally known film forming method. Examples of the film forming method include a calendar film forming method, a casting method in an organic solvent, an inflation extrusion method in a closed system, a T die extrusion method, a coextrusion method, and a dry lamination method.

Next, the pressure-sensitive adhesive layer can be formed by coating a pressure-sensitive adhesive composition solution onto a base material to form a coating film, and then drying the coating film under prescribed conditions (and heat-crosslinking depending on necessity). The coating method is not especially limited, and examples thereof include roll coating, screen coating, and gravure coating. As the drying condition, drying is conducted, for example, at a drying temperature of 80 to 150°C for a drying time of 0.5 to 5 minutes. After forming an applied film by applying a pressure-sensitive adhesive composition on a separator, the applied film may be dried in the above drying condition to form the pressure-sensitive adhesive layer 2. Thereafter, the pressure-sensitive adhesive layer 2 is bonded on the base material 1 together with the separator. In this manner, the dicing tape 11 is prepared.

The thermal bonding sheet with dicing tape 10, 12 can be produced in an ordinary method. For example, by bonding the pressure-sensitive adhesive layer 2 of the dicing tape 11 and the thermal bonding sheet 3, it is possible to produce the thermal bonding sheet with dicing tape 10.

In the thermal bonding sheet with dicing tape 10, it is preferred that the thermal bonding sheet 3 is covered with a separator. In one exemplary method, after bonding the dicing tape 11 and the thermal bonding sheet 3, the base separator that is laminated on the thermal bonding sheet 3 is peeled off, and on an exposed surface of the thermal bonding sheet 3 in the thermal bonding sheet with dicing tape 10 after peeling off the base separator, a separator is attached. In other words, it is preferred that the dicing tape 11, the thermal bonding sheet 3, and the separator are laminated in this sequence.

In the above embodiment, the thermal bonding sheet with dicing tape in which the dicing tape and the thermal bonding sheet are laminated was described. However, the thermal bonding sheet of the present invention may be provided in the state that it is not bonded with the dicing tape.

The thermal bonding sheet is preferably a thermal bonding sheet with both-side separators, which is sandwiched between two separators in the form where the dicing tape is not bonded. That is, a thermal bonding sheet with both-side separators in which the first separator, the thermal bonding sheet, and the second separator are laminated in this sequence is preferred.

Fig. 3 is a cross-sectional schematic view showing one embodiment of the thermal bonding sheet with both-side separators.

A thermal bonding sheet with both-side separators 30 shown in Fig. 3 has such a structure that a first separator 32, the thermal bonding sheet 3, and a second separator 34 are laminated in this sequence. As the first separator 32, and the second separator 34, the one that is identical to the base separator can be used.

The thermal bonding sheet may be in such a form that a separator is laminated on only one surface of the thermal bonding sheet in the form where the dicing tape is not bonded.

### (Method of manufacturing semiconductor device)

A method of manufacturing a semiconductor device according to the present embodiment includes:
a step of preparing the thermal bonding sheet, and
a thermal bonding step of thermally bonding a semiconductor chip on an adherend via the thermal bonding sheet (hereinafter, also referred to as the first manufacturing method).

The method of manufacturing a semiconductor device according to the present embodiment also includes:
a step of preparing the thermal bonding sheet with dicing tape,
a bonding step of bonding the thermal bonding sheet of the thermal bonding sheet with dicing tape, and a back surface of a semiconductor wafer,
a dicing step of dicing the semiconductor wafer together with the thermal bonding sheet to form a chip-like semiconductor chip,
a pickup step of picking up the semiconductor chip together with the thermal bonding sheet from the thermal bonding sheet with dicing tape, and
a thermal bonding step of thermally bonding the semiconductor chip onto the adherend via the thermal bonding sheet (hereinafter, also referred to as the second manufacturing method).

The method of manufacturing a semiconductor device according to the first manufacturing method is different from the method of manufacturing a semiconductor device according to the second manufacturing method in that the thermal bonding sheet is used alone, as compared with the method of manufacturing a semiconductor device according to the second manufacturing method where the thermal bonding sheet with dicing tape is used, and these methods are common in other points. In the method of manufacturing a semiconductor device according to the first manufacturing method, after preparing the thermal bonding sheet, the step of bonding the thermal bonding sheet with the dicing tape is conducted, and the subsequent steps can be conducted in the same manner as the method of manufacturing a semiconductor device according to the second manufacturing method. Hereinafter, the method of manufacturing a semiconductor device according to the second manufacturing method is described.

In the method of manufacturing a semiconductor device, the thermal bonding sheet with dicing tape 10, 12 is prepared (preparing step). The separator that is optionally provided onto the thermal bonding sheet 3, 3' is appropriately peeled off, and the dicing thermal bonding sheet 10, 11 of the present invention is used as follows. The manufacturing method is explained below referring to Fig. 3 using the case of the thermal bonding sheet with dicing tape 10 as an example.

First, a semiconductor wafer 4 is fixed onto the semiconductor attaching part 3a of the thermal bonding sheet 3 in the thermal bonding sheet with dicing tape 10 by press-bonding and by adhering and holding (mounting step). The present step is performed while pressing with a pressing means such as a press-bonding roll. A temperature upon mounting is not particularly limited, and is preferably in the range of 23 to 90°C.

As a semiconductor wafer 4, the one in which an electrode pad is formed on one side, and a silver thin film is formed on the outermost surface of the other side (hereinafter, also referred to as backside) is preferred. The thickness of the silver thin film can be, for example, 10 nm to 1000 nm. Between the semiconductor wafer 4 and the silver thin film, a titanium thin film may further be formed. The thickness of the titanium thin film can be, for example, 10 nm to 1000 nm. When the silver thin film is formed, it is possible to thermally bond a semiconductor chip 5 and the thermal bonding sheet 3 firmly in the later-described thermal bonding step. Also when the titanium thin film is formed, the reliability of the electrode is improved. The silver thin film, and the titanium thin film can be formed, for example, by vapor deposition.

Next, dicing of the semiconductor wafer 4 is performed (dicing step). With this operation, a semiconductor chip 5 is formed by cutting the semiconductor wafer 4 into a prescribed size to make it into individual pieces. The dicing method is not particularly limited, but is performed following an ordinary method from the circuit face side of the semiconductor wafer 4, for example. Further, a cutting method, so-called full cut, in which cutting-in is performed to the thermal bonding sheet with dicing tape 10, can be adopted in the present step, for example. The dicing apparatus that is used in the present step is not especially limited, and a conventionally known apparatus can be used. Further, because the semiconductor wafer 4 is adhered and fixed by the thermal bonding sheet with dicing tape 10, chip breakage and chip fly can be suppressed, and at the same time, damage of the semiconductor wafer 4 can be suppressed.

Picking up of the semiconductor chip 5 is performed to peel off the semiconductor chip that is adhered and fixed to the thermal bonding sheet with dicing tape 10 (pickup step). The method of picking up is not especially limited, and various conventionally known methods can be adopted. Examples thereof include a method of pushing up an individual semiconductor chip 5 from the thermal bonding sheet with dicing tape 10 side using a needle and picking up the semiconductor chip 5 that is pushed up with a picking up apparatus.

As the pickup condition, a needle pushing up rate is preferably 0.5 to 100 mm/sec., more preferably 5 to 10 mm/sec. in terms of prevention of chipping.

Here, the pickup is performed after irradiating the pressure-sensitive adhesive layer 2 with the ultraviolet ray if the pressure-sensitive adhesive layer 2 is of a radiation curable. With this operation, the adhesive strength of the pressure-sensitive adhesive layer 2 to the thermal bonding sheet 3 decreases, and the semiconductor chip 5 is easily peeled off. As a result, the pickup becomes possible without damaging the semiconductor chip. The conditions during ultraviolet ray irradiation such as the radiation strength and the radiation time are not especially limited, and may be appropriately set as necessary. Any known light source for irradiation with ultraviolet ray can be used. When the pressure-sensitive adhesive layer is cured in advance by irradiating with ultraviolet rays, and the cured pressure-sensitive adhesive layer and the thermal bonding sheet are bonded, the irradiation with ultraviolet rays here is not required.

Then, the picked semiconductor chip 5 is die attached (thermally bonded) to an adherend 6 via the thermal bonding sheet 3 (thermal bonding step). Examples of the adherend 6 include a lead frame, a TAB film, a substrate, and a semiconductor chip that is separately produced. The adherend 6 may be a deformable adherend that can be deformed easily or may be a non-deformable adherend such as a semiconductor wafer that is difficult to be deformed.

Metal lead frames such as a Cu lead frame and a 42 Alloy lead frame can be used as the lead frame. As the substrate, a conventionally known one can be used. An organic substrate made of glass epoxy, BT (Bismaleimide-Triazine), polyimide, and the like can be exemplified. Among these, by using a metal lead frame, it is possible to integrate with the metallic fine particles by thermal bonding. As the substrate, an insulating circuit substrate in which a coper circuit board is laminated on an insulating board such as a ceramic plate can be recited. By using an insulating circuit substrate, it is possible to produce, for example, a power semiconductor device that controls or supplies electric power.

In the thermal bonding step, metallic fine particles are sintered by heating, and a residual organic component such as a thermally decomposable binder is thermally decomposed or volatilized as necessary. The heating temperature can be preferably 180 to 400°C, more preferably 190 to 370°C, further preferably 200 to 350°C. The heating time can be preferably 0.3 to 300 minutes, more preferably 0.5 to 240 minutes, further preferably 1 to 180 minutes. The thermal bonding may be conducted under a pressurized condition. The pressurizing condition is preferably within the range of 1 to 500 kg/cm², more preferably within the range of 5 to 400 kg/cm². The thermal bonding under a pressurized condition can be carried out by an apparatus capable of conducting heating and pressurizing simultaneously such as flip chip bonder, for example. Parallel plate pressing is also applicable.

Next, if necessary, the tip of a terminal part (inner lead) of the adherend 6 is electrically connected to an electrode pad (not shown in the figures) on the semiconductor chip 5 with a bonding wire 7 (wire bonding step). Examples of the bonding wire 7 that can be used include a gold wire, an aluminum wire, and a copper wire. The temperature when performing the wire bonding is in the range of 23 to 300°C and preferably in the range of 23 to 250°C. The heating time is a few seconds to a few minutes. The connection is in a heated state so that the temperature becomes in the above-described range, and it is performed using both the vibration energy due to ultrasonic waves and the compression energy due to the applied pressure.

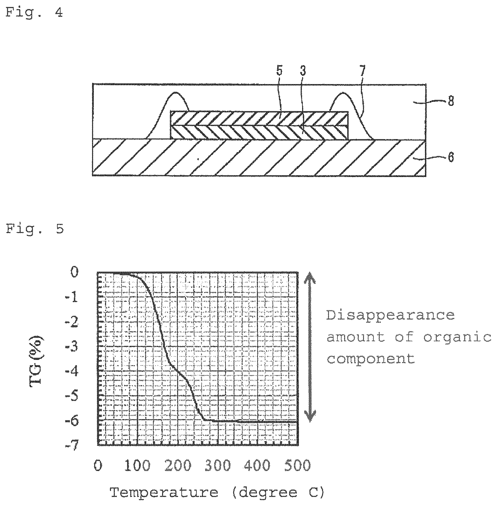

Further, if necessary, the semiconductor chip 5 is sealed with a sealing resin 8 as shown in Fig. 4 (sealing step). The present step is performed to protect the semiconductor chip 5 and the bonding wire 7 that are mounted on the adherend 6. The present step is performed by molding a resin for sealing with a mold. Example of the sealing resin 8 that is used include epoxy resins. The resin sealing is performed normally at a heating temperature of 175°C for 60 to 90 seconds. However, the present invention is not limited to this and it can be performed by curing at 165 to 185°C for a few minutes for example. With this, the sealing resin 8 is cured. In the present sealing step, a method of embedding the semiconductor chip 5 into a sheet-like sealing sheet (see, JP-A 2013-7028, for example) can also be employed. Besides the molding of a sealing resin by a die, a gel sealing type in which silicone gel is poured into a case type container is also applicable.

The sealing resin 8 that is not sufficiently cured in the sealing step is cured completely by heating (post curing step). The heating temperature in the present step differs depending on the type of the sealing resin. However, it is in the range of 165 to 185°C for example, and the heating time is about 0.5 to 8 hours.

The thermal bonding sheet, and the thermal bonding sheet with dicing tape according to the present invention can be favorably used in laminating a plurality of semiconductor chips to achieve three-dimensionally mounting. At this time, a thermal bonding sheet and a spacer may be laminated between semiconductor chips, or not a spacer but only a thermal bonding sheet may be laminated between semiconductor chips, and these can be appropriately changed depending on the manufacturing condition, use application and the like.

Also, the thermal bonding sheet, and the thermal bonding sheet with dicing tape of the present invention can be used for thermally bonding two objects without limited to the application exemplified above.

### EXAMPLES

Hereinafter, the present invention will be specifically described by Examples, however, the present invention is not limited to the following Examples.

The components used in the examples were as follows.

Sinterable metallic particle-containing paste: ANP-1 manufactured by Applied Nanoparticle Research Laboratory
Thermally decomposable binder: PPC (polypropylene carbonate resin), "QPAC 40" manufactured by Empower, solid at 23°C.

Basic substance: triethanolamine (TEA): manufactured by Tokyo Chemical Industry Co., Ltd.

Basic substance: trioctylamine (TOA): manufactured by Tokyo Chemical Industry Co., Ltd.

Basic substance: tributylamine (TBA): manufactured by Tokyo Chemical Industry Co., Ltd.

Organic solvent: methyl ethyl ketone (MEK)

### <Examples 1 to 3, Comparative Examples 1 and 2>

A sinterable metallic particle-containing paste, a thermally decomposable binder and a basic substance shown in Table 1 were charged into a rotation/revolution mixer (made by Shinky, ARE-310) together with an organic solvent at the compounding amounts shown in Table 1, and the mixture was stirred at 2000 rpm for 8 minutes to prepare a varnish. The obtained varnish was coated on a release-treated film ("MRA 38" manufactured by Mitsubishi Plastics, Inc.) and dried. Coating was carried out using an applicator so that the thickness of the coating film after drying was 45 µm. Drying was carried out with an explosion-proof dryer. The drying condition was at 110°C for 5 minutes. In this way, thermal bonding sheets with a thickness of 45 µm according to Examples and Comparative Examples were obtained.

### <<Evaluation>>

With respect to the following items, samples of Examples and Comparative Examples were evaluated. The results are shown in Table 1.

### (The way to determine 95% weight loss temperature by thermogravimetry)

TG 8120 manufactured by Rigaku was used for measuring the 95% weight loss temperature of the organic component by the thermogravimetry method. Change in the weight of the sample was measured by putting 10 mg of thermal bonding sheet (before sintering) in an aluminum container and measuring in a temperature range of 25°C to 500°C under an air atmosphere at a heating rate of 10°C/min. As the weight loss amount of the organic component, the weight loss amount at 500°C was set to 100%, whereas the temperature at which 95% of the weight disappeared was read to obtain a 95% weight loss temperature. Fig. 5 shows a graph obtained by thermogravimetry for the thermal bonding sheet of Example 1.

### (Reliability Evaluation - Measurement of Remaining Bonding Area Ratio)

A silicon chip (a silicon chip having a thickness of 350 µm, a length of 5 mm, and a width of 5 mm) having a Ti layer (thickness of 50 nm) and an Ag layer (thickness of 100 nm) formed in this order on the back surface was prepared. The prepared thermal bonding sheet was overlaid on the Ag layer surface of the prepared silicon chip. In this state, it was passed through a laminator. Conditions of the laminator were temperature of 70°C, pressure of 0.3 MPa, speed of 10 mm/sec.

Separately, a copper plate (copper plate with thickness of 3 mm) whose entire surface was covered with an Ag layer (thickness of 5 µm) was prepared. Onto the prepared copper plate, a thermal bonding sheet with a silicon chip (prepared as above) was temporarily adhered. The pressure at the time of temporary adhesion was 0.1 MPa. Further, at the time of temporary adhesion, the copper plate was previously heated to 70°C.

Subsequently, the thermal bonding sheet was sintered under pressing and heating conditions to bond the silicon chip and the copper plate (pressure of 10 MPa, heating rate of 90°C/min, sintering temperature of 200°C, sintering time of 1.5 minutes). For the bonding, a sintering apparatus (HTM-3000, manufactured by Hakuto Co., Ltd.) was used. The pressing was carried out by a flat plate press, and the pressing was always maintained during the heating step and the sintering step. In addition, the atmosphere during the heating and the sintering was set to the air atmosphere.

After the heating (after completion of the sintering step), air-cooling was carried out until 170°C., and thereafter water-cooling was carried out until 80°C. Water-cooling was carried out by a water-cooled cooling plate provided in the pressing plate. Thus, a sample for evaluation was obtained.

Next, the evaluation sample was placed in a cooling-thermal shock test machine ("TSE-103ES" manufactured by ESPEC Corp.), and subjected to a cooling-thermal shock of - 40°C to 200°C for 100 cycles. At this time, the temperature was held at -40°C and 200°C for 15 minutes, respectively.

After 100 cycles, using an ultrasonic imaging apparatus [SAT] ("FineSAT II" manufactured by Hitachi Construction Machinery Finetech Co., Ltd.), in order to confirm the part where the silicon chip and the copper plate were bonded by the sintered layer, imaging was carried out. The transducer (probe) used was PQ-50-13: WD [frequency of 50 MHz] and the imaging mode was "reflection".

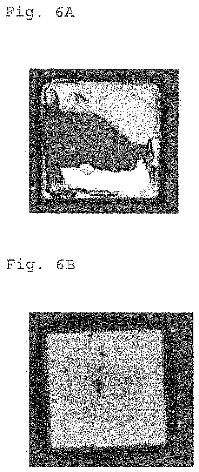

Using an image analysis software ("Image J", an open source software developed at the National Institutes of Health), the area (remaining bonding area) of the part where boding remained in the obtained image was obtained, and the ratio of the remaining bonding area to the entire area (remaining bonding area ratio) was calculated. The image obtained by the ultrasonic imaging apparatus was binarized and displayed in binary so that the part where the silicon chip and the copper plate were peeled off was white, and the part where the bonding remained was black (the threshold value was 127. Among the histogram divided into 256 divisions with the tone of 0 to 255, 0 to 127 were binarized as a black part and 128 to 255 were binarized as a white part). A case where the remaining bonding area ratio was 30% or more was evaluated as "○", and a case where the remaining bonding area ratio was lower than 30% was evaluated as "X". Figs. 6A and 6B show ultrasonic images showing results of bonding reliability test about thermal bonding sheets of Example 2 and Comparative Example 1, respectively.

| [Table 1] | | Example 1 | Example 2 | Example 3 | Comparative Example 1 | Comparative Example 2 |
|---|---|---|---|---|---|---|
| Material | Thermally decomposable binder | PPC | PPC | PPC | PPC | PPC |
| | Basic substance | TEA | TEA | TOA | - | TBA |
| | Sinterable metallic particle-containing paste | ANP1 | ANP1 | ANP1 | ANP1 | ANP1 |
| Compounding ratio (parts) | Thermally decomposable binder | 1 | 1 | 1 | 1 | 1 |
| | Basic substance | 1 | 0.3 | 0.1 | 0 | 0.3 |
| | Sinterable metallic particle-containing paste | 91 | 91 | 91 | 91 | 91 |
| 95% weight loss temperature of basic substance (°C) | | 267 | 267 | 263 | - | 138 |
| 95% weight loss temperature of organic component (°C) | | 254 | 278 | 270 | 310 | 305 |
| Sintering bonding reliability of sheet | | ○ | ○ | ○ | X | X |

### (Results and Consideration)

In Examples 1 to 3, the reliability evaluation was good. On the other hand, in Comparative Examples 1 and 2, the reliability evaluation was inferior. Also in the ultrasonic images of Figs. 6A and 6B, the remaining bonding area ratio was 50% in Example 2, while it was 10% in Comparative Example 1. This is presumed to be due to the fact that in each of Comparative Examples 1 and 2, the 95% weight loss temperature of the organic component exceeded 300°C, and sintering of the sinterable metallic particles was inhibited by the organic component.

### DESCRIPTION OF REFERENCE SIGNS

1: Base material
2: Pressure-sensitive adhesive layer
3, 3': Thermal bonding sheet
4: Semiconductor wafer
5: Semiconductor chip
6: Adherend
7: Bonding wire
8: Sealing resin
10, 12: Thermal bonding sheet with dicing tape
11: Dicing tape
30: Thermal bonding sheet with both-side separators
31: Precursor layer that is to become a sintered layer by heating
32: First separator
34: Second separator

## Claims

1. A thermal bonding sheet, comprising a precursor layer that is to become a sintered layer by heating,
wherein
the precursor layer includes sinterable metallic particles and an organic component,
a 95% weight loss temperature of the organic component is 150°C or more and 300°C or less when thermogravimetry of the thermal bonding sheet is performed under an air atmosphere at a heating rate of 10°C/min, and
wherein the organic component includes an organic binder and a basic substance, wherein the organic binder is a thermally decomposable binder which is a material having a carbon concentration obtained by the energy dispersive X-ray analysis after temperature rise from 23°C to 400°C at a heating rate of 10°C/min in an air atmosphere of 15% by weight or less even when it is contained in the precursor layer, and
wherein the amount of the basic substance is from 1 to 150 parts by weight with respect to 100 parts by weight of the thermally decomposable binder.

2. The thermal bonding sheet according to claim 1, wherein a 95% weight loss temperature of at least one of the basic substances is 150°C or more and 300°C or less when thermogravimetry of the thermal bonding sheet is performed under an air atmosphere at a heating rate of 10°C/min.

3. The thermal bonding sheet according to claim 1 or 2, wherein the basic substance is a tertiary amine.

4. A thermal bonding sheet with dicing tape, comprising:
a dicing tape, and
the thermal bonding sheet according to any one of claim 1 to 3 laminated on the dicing tape.

## Patentansprüche

1. Thermisch bindende Folie, umfassend eine Vorläuferschicht, die durch Erwärmen zu einer Sinterschicht werden soll,
wobei
die Vorläuferschicht sinterbare Metallpartikel und eine organische Komponente beinhaltet,
eine 95%ige Gewichtsverlusttemperatur der organischen Komponente 150 °C oder mehr und 300 °C oder weniger beträgt, wenn die Thermogravimetrie der thermisch bindenden Folie unter einer Luftatmosphäre bei einer Erwärmungsgeschwindigkeit von 10 °C/min durchgeführt wird, und
wobei die organische Komponente ein organisches Bindemittel und eine Grundsubstanz enthält, wobei das organische Bindemittel ein thermisch zersetzbares Bindemittel ist, bei dem es sich um ein Material mit einer Kohlenstoffkonzentration handelt, die durch die energiedispersive Röntgenanalyse nach einem Temperaturanstieg von 23 °C auf 400 °C bei einer Änderungsgeschwindigkeit von 10 °C/min in einer Luftatmosphäre von 15 Gew.-% oder weniger erhalten wird, selbst wenn es in der Vorläuferschicht enthalten ist, und
wobei die Menge der Grundsubstanz 1 bis 150 Gewichtsteile in Bezug auf 100 Gewichtsteile des thermisch zersetzbaren Bindemittels beträgt.

2. Thermisch bindende Folie nach Anspruch 1, wobei eine 95%ige Gewichtsverlusttemperatur von mindestens einer der Grundsubstanzen 150 °C oder mehr und 300 °C oder weniger beträgt, wenn die Thermogravimetrie der thermisch bindenden Folie unter einer Luftatmosphäre bei einer Erwärmungsgeschwindigkeit von 10 °C/min durchgeführt wird.

3. Thermisch bindende Folie nach Anspruch 1 oder 2, wobei die Grundsubstanz ein tertiäres Amin ist.

4. Thermisch bindende Folie mit Schnittband, umfassend:
ein Schnittband, und
eine thermisch bindende Folie nach einem der Ansprüche 1 bis 3, die auf das Schnittband laminiert ist.

## Revendications

1. Feuille de thermocollage comprenant une couche de précurseur destinée à devenir une couche frittée par chauffage,
dans laquelle
la couche de précurseur comprend des particules métalliques frittables et un composant organique,
la température de perte de masse de 95 % du composant organique est supérieure ou égale à 150 °C et inférieure ou égale à 300 °C quand une analyse thermogravimétrique de la feuille de thermocollage est mise en œuvre sous atmosphère d'air à une vitesse de chauffe de 10 °C/min, et
dans laquelle le composant organique comprend un liant organique et une substance de base, dans laquelle le liant organique est un liant thermodécomposable qui est un matériau dont la concentration en carbone obtenue par spectroscopie de rayons X à dispersion d'énergie après une hausse de température de 23 °C à 400 °C à une vitesse de chauffe de 10 °C/min sous atmosphère d'air est inférieure ou égale à 15 % en masse même lorsqu'il est contenu dans la couche de précurseur, et
dans laquelle la quantité de substance de base est de 1 à 150 parties en masse par rapport à 100 parties en masse du liant thermodécomposable.

2. Feuille de thermocollage selon la revendication 1, dans laquelle une température de perte de masse de 95 % d'au moins une des substances de base est supérieure ou égale à 150 °C et inférieure ou égale à 300 °C quand une analyse thermogravimétrique de la feuille de thermocollage est mise en œuvre sous atmosphère d'air à une vitesse de chauffe de 10 °C/min.

3. Feuille de thermocollage selon la revendication 1 ou 2, dans laquelle la substance de base est une amine tertiaire.

4. Feuille de thermocollage à ruban à découper, comprenant :
un ruban à découper, et
la feuille de thermocollage selon l'une quelconque des revendications 1 à 3 laminée sur le ruban à découper.
